# EUROPEAN PATENT APPLICATION

(11) **EP 1 460 469 A1**
(43) Date of publication of application: **22.09.2004**
(21) Application number: 03405182.1
(22) Date of filing: 17.03.2003
(51) Int. Cl.: G02B 27/10, G02B 27/09

(54) **Optical arrangement and linear laser emitting device**

(71) Applicant: Heptagon Oy, 8048 Zürich (CH)
(72) Inventor: Kettunen, Ville, 8048 Zürich (CH)
(74) Representative: Frei, Alexandra Sarah

(57) **Abstract**

An optical arrangement for light emitted by a linear laser emitting means and a linear laser emitting device comprise an optical distribution means arranged to distribute light emitted by at least one of the emitters to overlap, on a target plane, with light from at least one of the other emitters. The optical distribution means and optionally an optical redirection means are implemented as diffractive optical elements. For a material being processed that is located at least approximately in the target line, the invention allows to achieve a more even distribution of light or light energy over the material.

## Description

### FIELD OF THE INVENTION

The invention relates to the field of micro-optics. It relates to an optical arrangement for light emitted by a linear laser emitting means and to a linear laser emitting device as described in the preamble of claims 1 and 10, respectively.

### BACKGROUND OF THE INVENTION

Semiconductor laser bars are used in growing number of industrial processing and medical tasks, e.g. where the application of high power is needed, such as in materials processing, welding or in laser printers. A laser bar is a monolithic, linear array of typically edge emitting lasers.

A typical laser bar is, for example, about 10 mm * 1 mm * 0.1 mm in size and contains 20 to 70 individual emitters. With a specified operating lifetime of more than 10,000 hours, bars typically supply 40 to 50 W of continuous-wave output at wavelengths from 800 nm (nanometer) to 980 nm. Non-standard emitter array sizes and wavelength / power combinations also exist.

One of the problems related to use of laser bars is the fact that variations in the emitting performance among emitters within the bar directly influence the output of the whole laser bar in terms of beam quality and output distribution. In the worst case, when one or more emitters are non-functional, the output beam exhibits clearly measurable dips or even zeroes in its intensity distribution. Such variations in the intensity distribution are of special concern in applications where the output beam is used to process materials since local intensity minima directly lead to insufficient processing. Optical arrangements for controlling the light emitted by individual emitters by microlenses are known.

### DESCRIPTION OF THE INVENTION

It is an object of the invention to create an optical arrangement for light emitted by a linear laser emitting means and to a linear laser emitting device of the type mentioned initially, which overcomes the disadvantages mentioned above.

These objects are achieved by an optical arrangement for light emitted by a linear laser emitting means and to a linear laser emitting device according to the claims 1 and 10.

The optical arrangement comprises an optical distribution means arranged to distribute light emitted by at least one of the emitters to overlap, on a target line, with light from at least one of the other emitters. Such light mixing refers to light that is emitted by several sources being arranged in such a way that the light from different sources overlaps. Mixing reduces the influence of a single source or emitter on a local shape of the overall light distribution of all of the sources. For a material being processed that is located at least approximately in the target line, this offers the advantage of a more even distribution of light or light energy over the material. Conversely, mixing the individual emitter outputs together reduces a sensitivity of the laser output of the optical arrangement to local variations of the individual emitter outputs.

For an optical redirection means being located at least approximately in the target line, the same advantage is obtained on the target line itself and also within a redirected plane or beam of light.

The advantage of using diffractive optical elements (DOEs) lies in their greater flexibility regarding mixing options, including the possibility to realise mixings that are not otherwise feasible. Other advantages with respect to classical refractive optics are reduced weight and the possibility to easily mass-produce the required optical components by means of e.g. embossing or injection moulding.

In a preferred embodiment of the invention, the light emitted by at least one of the emitters overlaps with light from at least two or half or essentially all of the other emitters. The two other emitters preferably are emitters adjacent to the at least one emitter. A maximal evening out of intensity is obtained when the light of each emitter is spread out to cover substantially the same area as that covered by each of the other emitters. For arrays with a large number of emitters, it is preferred to mix the light not of all emitters, but only of a substantial number, such that a particular location in the target line is illuminated by said number of emitters, e.g. from four emitters to half of the total number of emitters. This reduces the requirements on the optical distribution means and/or allows smaller dimensions of the arrangement, since only smaller angles for spreading the light are required.

In a further preferred embodiment of the invention, a plane of light emitted by the totality of the emitters and mixed by the optical distribution means has, in the target plane, a linear extension, in a direction parallel to a main extension of the optical distribution means, that is substantially larger or substantially smaller than the extension of the optical distribution means in said direction. This means that the light may be focussed on a smaller target line on either the material being processed or on a optical redirection means that e.g. collimates the light. Alternately, the light can be spread out to cover a target line that is longer than the linear laser emitting means associated with the optical arrangement.

The optical arrangement comprises an optical distribution means which in turn is made of either a single element or a plurality of distribution elements, each of which is preferably associated with a single laser emitting element of the linear laser emitting means. The linear laser emitting device optionally comprises an optical redirection means such as a lens or diffractive element which either is an element separate from the optical distribution means or whose function is realised together with the light distribution in a single optical element. For example, if the redirection means is a collection optic with a plano-convex lens, this may be realised by adding the diffractive optical elements required in the mixing to the plane side of the lens by replication techniques such as embossing or moulding.

The single distribution element or the plurality of distribution elements preferably are diffractive optical elements (DOE). They allow for greater flexibility offered by the DOEs in the available light distribution or mixing options. These include the possibility to realise mixings that are not otherwise feasible, reduced weight over possible solutions consisting of classical refractive optics, and the easy mass-production of the required optical components by means of e.g. injection moulding.

Of course, DOEs also involve refraction, and light passing through classical optical devices is also subject to diffractive effects. However, in classical optical devices such as classical lenses, prisms, mirror elements etc., the effects of diffraction are negligible and the design of such a device is done according to the rules of refractive optics. Conversely, DOEs are designed in order to exploit diffraction and are manufactured to comprise controlled microscopic structures causing controlled and desired diffractive behaviour.

The desired and essential properties of DOEs, which may also be designated as micro-optical elements, as opposed to conventional optics, are based on fine structures causing refraction and/or diffraction, the structures having characteristic depths/heights and often also widths of typically a few micrometers (µm), for example of 0,5 µm - 200 µm, preferably of between 1 µm and about 50 µm or between 1 µm and about 30 µm. In other words, the characteristic profile depths and the profile widths are of the order of a few wavelengths up to a few tens of wavelengths for refractive optics and of about one wavelength up to a few wavelengths for diffractive optics. As a rule of thumb, micro-optical elements comprise structures for which the phase relation of radiation present at adjacent locations on the structure is well-defined and controlled. This is in contrast to classical optical elements, where the behaviour of the radiation at different elements of the structure is described in terms of refractive effects alone. DOEs or micro-optical elements, thus, as opposed to classical optical elements, are regarded as having structures which are such that the wave nature of the light has to be taken into account and participates in the desired effect that the micro-optical element has upon radiation. In again other words, a DOE is an optical element that controls light via an interaction between the wave front and the surface profile, as opposed to traditional or refractive optical element where the shape of the element is used to bend the light.

Miniaturisation of the optical arrangement is preferably achieved by combining diffractive effects for mixing and refractive effects for redirection, or by using a double sided diffractive element where the first surface is used to mix the light and the second surface performs redirection or beam shaping.

A linear laser emitting device according to the invention comprises a linear laser emitting means with a plurality of emitters and an optical distribution means as described above.

Further preferred embodiments are evident from the dependent patent claims.

### BRIEF DESCRIPTION OF THE DRAWINGS

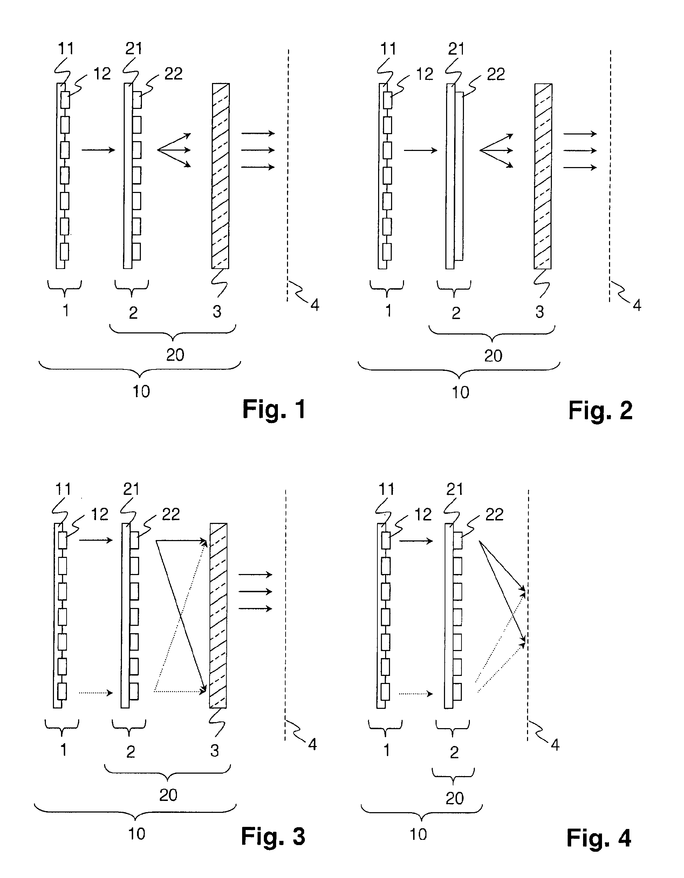

The subject matter of the invention will be explained in more detail in the following text with reference to preferred exemplary embodiments which are illustrated in the attached drawings, in which Figures 1 through 4 schematically show preferred embodiments of optical arrangements according to the invention. The reference symbols used in the drawings, and their meanings, are listed in summary form in the list of reference symbols. In principle, identical parts are provided with the same reference symbols in the figures.

### DETAILED DESCRIPTION OF PREFERRED EMBODIMENTS

Figure 1 shows a preferred embodiment of an optical arrangement 20 according to the invention. The optical arrangement 20 comprises an optical distribution means or mixing component 2 and optionally an optical redirection means 3. The optical distribution means 2 comprises a transparent distribution means substrate 21 carrying one or more distribution elements 22. Together with a linear laser emitting means 1, the optical arrangement 20 forms a linear laser emitting device 10 according to the invention. The linear laser emitting means 1 comprises a laser substrate 11 and laser emitters 12. The abovementioned elements are arranged such that light emitted by the emitters 12 is mixed by the optical distribution means 2, is optionally redirected by the optical redirection means 3 and hits a target surface or, more specifically, a target line 4. The direction and distribution of a few selected beams of light is indicated by arrows.

The term "target line" expresses that a main distribution of light traversing the optical arrangement 20 is concentrated around the plane of the paper of figure 1. A projection of the light beam intersecting a target plane that is perpendicular to the paper plane and comprises the target line has the shape of an elongated rounded rectangle. For the optical arrangement 20 configured for a single row of emitters 12 on the laser bar 1, the shape is mainly linear in appearance and extends along the target line 4 as indicated in the figures. Since laser bars 1 typically have ratios between width and height of 10 or more to 1, when the optical arrangement 20 has no effect or only mixes the light, said shape has a similar aspect ratio. In a preferred embodiment of the invention, the optical arrangement 20, in addition to mixing the light in one direction, focuses the light in the other direction. This produces a very thin line, with or without changing its length, and with ratios from e.g. 50:1 to 100:1.

In other embodiments of the invention, the light is shaped to form, on the target surface, a target shape 4 that is e.g. circular or approximately square.

In another preferred embodiment of the invention, the linear laser emitting means 1 comprises a matrix of emitters. e.g. a stack of linear laser bars, each linear laser bar comprising a line of emitters 12. The stack of linear laser bars forms a matrix of emitters 12 in two dimensions. Accordingly, the optical distribution means 2 comprises a planar or matrix arrangement of distribution elements 22 or a single distribution element 22 configured to mix the emitted light from all the stacked linear laser bars in two dimensions. Alternatively, each of the linear laser bars is associated with its own linear optical arrangement 20, and both the laser bars and the linear optical arrangements 20 are stacked, providing a cost-effective arrangement. The mixed light is projected directly or via the optical redirection means 3 onto a target plane. The target line 4 shown in the figures defines the intersection of the target plane with the paper plane.

Each of the emitters 12 has a given output distribution or divergence. Typically the divergence of the emitters, and accordingly of the whole bar, is approximately 30 degrees by 10 degrees, with the larger divergence being in the direction perpendicular to the direction of the array of emitters. In an edge emitting laser, the divergence depends on a thickness of the emitting layer.

A distance between the emitters 12 and the optical distribution means 2 typically ranges from a few hundred microns to few millimetres. After propagating for this distance from the emitter array, the emitted light hits the optical distribution means 2, i.e. a micro-optical component consisting of a glass or plastic distribution means substrate 21 into which an array of sub-elements or distribution elements 22 are fabricated. Alternatively the distribution elements 22 are arranged on top of the substrate 21, as shown in figure 1. The distribution elements 22 are e.g. manufactured as separate units by being moulded or embossed separately and then combined with a substrate or scaffolding to form the optical distribution means 2.

The distance between the laser emitting means 1 and the optical distribution means 2 should be as small as possible, resulting in no source overlap, smaller individual elements and an easier design. Typically, this distance is few hundred microns, e.g. 250-500 micrometers. Shorter distances make assembly difficult, while larger distance make the control of the light more tricky. The distance between the optical distribution means 2 and the optical redirection means 3 or the target line 4 should, on the other hand be as long as possible. This makes the elements easier to fabricate, since small redirection angles imply large features. In theory there is no minimum distance, but in practice e.g. mixing the diodes at the ends of a 10 millimetre laser bar together on a line significantly shorter than 10 millimetres would be very difficult. But only in terms of making the actual element, design is not a problem. From the optical point of view, there is no maximum distance, but in practice the total length of the system is often critical and so distances under 5 cm are usually preferred. Typical values would be a few millimetres, e.g. 5-10 millimetres, depending on how much mixing is done. If just neighbours are to be mixed, then the distance can be reduced to 1-2 millimetres. On the other hand, mixing the whole 10 millimetre bar requires easily 20 millimetres.

Figure 2 shows another preferred embodiment of the invention, comprising a single distribution element 22 with an optical function obtained by combining the optical functions of several individual elements 22.

The optical function of the optical distribution means 2 is to mix light coming from a specific single emitter with light coming from neighbouring emitters. In an ideal mixing case, light from all emitters 12 is mixed together. In a minimal case, light from a specific emitter is mixed only with that of its immediate neighbours, that is, the mixing is done among the light of three emitters 12. In intermediate cases, light from more than three and, for example, up to half the total number of emitters 12 is mixed.

An approach according to the minimal case or intermediate cases is preferable when the number of emitters 12 is high, since complete mixing then typically requires that the opening angle of the cone of light generated by a distribution element 22 is relatively large. A large opening angle implies that the diffractively active feature sizes in the distribution element 22 are relatively small and thus difficult to fabricate.

Figures 3 and 4 show two different preferred embodiments for the ideal or complete mixing between all the emitters 12: Figure 3 shows the mixing done such that overall beam size is maintained. In terms of single sub-elements 22, or for each section of a single element 22, this means that each individual element 22 must spread the light over an area that matches the size of the input beam hitting the mixing component 2.

Figure 4 also shows an embodiment without the optical redirection means 3, i.e. with the mixed light hitting the target line 4 with the material being processed directly. Alternatively, a target line 4 could also be illuminated according to figure 3, or the mixing according to figure 4 could be combined with an optical redirection means 3.

Alternatively the mixing may be done in a manner that the beam size is changed during the mixing. For an embodiment *without* the optical redirection means 3, this means that a plane or beam of light emitted by the totality of the emitters 12 and mixed by the optical distribution means 2 has, in the target plane, a linear extension, in a direction parallel to a main extension, i.e. in the paper plane of the optical distribution means 2 that is substantially larger or substantially smaller than the extension of the optical distribution means 2 in said direction. For an embodiment that *does* comprise optical redirection means 3, this means that a plane of light leaving the optical redirection means 3 has a linear extension, in a direction parallel to a main extension, in the paper plane of the figures 2 and 3, that is substantially larger or substantially smaller than the extension of an active part of the optical distribution means 2 parallel to said direction.

In other preferred embodiments of the invention, the plane or beam of light emitted by the totality of the emitters 12 is shaped by the optical distribution means 2 to form, on the target surface, a target shape 4 that is e.g. circular or approximately square. This allows to use the laser bar as a high power source, concentrating the light of all emitters 12 on a predetermined shape.

In another preferred embodiment of the invention, a controlled uneven distribution is achieved on purposes by appropriate design of the optical arrangement 20, i.e. of the distribution means 2 and/or the optical redirection means 3. This serves to heat different target areas with controlled different amounts of energy.

A phase function describes the DOE's influence on a wave front as a function of the position and can be used to determine the required surface profile of the DOE in straightforward manner. In general, the design process of a DOE consists of solving a phase function performing a desired optical function such as focusing or beam shaping, and then using simple equations that connect the phase function to the depth of the surface profile.

The mixed light is optionally collected and typically redirected using an additional optical redirection means 3, such as a conventional lens. A diffractive element may also be used as an optical redirection means 3, especially if some additional beam shaping is required.

There exist several ways to implement mixing using diffractive optical elements such as the distribution elements 22: An element may be a so called deterministic or tailored diffuser which spreads the light hitting the element over a specified angular range and with given relative intensity. Unlike a classical diffuser, where a cone of light generated by the element is determined by an average feature size of the element, a great deal of freedom is available in the selection of the shape, size and relative distribution of light over the angular range of each distribution element 22. Thus virtually any type of mixing can be realised. Other advantages of tailored diffusers are that they are not sensitive to alignment and do not affect a polarisation of the input beam. A preferred diffractive tailored diffuser is a periodic or pseudo-periodic element with binary, multi-level or continuous surface profile and with average feature sizes ranging from about one wavelength to tens of microns, depending the required function according to the final e.g. manufacturing application.

The element may also be a mapping type of element, where the input and output of the element are connected via a one-to-one mapping. Such elements are often also referred as beam shapers. The key difference to the abovementioned diffuser type elements is that in diffuser type elements a single point on the input plane contributes essentially to all points on the output, while here the contribution is only to a single point or to a few discrete points. Use of mapping type elements requires that the input field is well known. Any solution where the element phase function resembles that of a lens is obtained via one-to-one mapping.

In a preferred embodiment of the invention, the optical arrangement 20 is miniaturised and manufactured as a single micro-optical module instead of a substrate and separately fabricated distribution elements that may be easily mass produced via techniques such as injection moulding. Further, for example, the function of the optical mixing component or distribution means 2 and the function of the optical redirection means 3 are combined and implemented as a single unit. In yet a further preferred embodiment of the invention, this unit is a single solid manufactured in one piece by replication techniques, e.g. by moulding or embossing. The unit has distinct essentially refractive and essentially diffractive elements. For example, where the collection optic 3 is a piano-convex lens, the diffractive optical elements 22 required for mixing are added to the planar side of the 3 lens by replication techniques. Alternatively, miniaturisation may also be achieved by using a double sided diffractive element where the first surface mixes the light and the second surface performs redirection.

In special cases it is possible to realise a single distribution element 22 according to figure 2 as a refractive element. Such cases include but are not limited to all cases where the phase function of a corresponding diffractive optical element resembles the phase function of a lens, since such a phase function can be unwrapped to obtain a corresponding refractive element. An example of this is the minimum mixing case where the most efficient mixing element is in fact a diffractive or refractive lens with focal length proportional to the spacing of the emitters.

"Unwrapping" denotes a process where all jump of N × 2π (where N is an integer) in the phase function are removed in such a manner that the resulting phase function is continuous in a sense of being free of N x 2π jumps (smaller jumps may still occur). The process is always possible for one dimensional or separable phase functions, but typically impossible for non-separable two dimensional phase functions.

### LIST OF DESIGNATIONS

- 1: linear laser emitting means, laser diode bar
- 10: Linear laser emitting device
- 11: laser substrate
- 12: emitters
- 2: optical distribution means
- 20: optical arrangement
- 21: distribution means substrate
- 22: distribution elements
- 23: single distribution element
- 24: combined distribution and redirection means
- 3: optical redirection means
- 4: target line, target plane

## Claims

1. Optical arrangement (20) for light emitted by a linear laser emitting means (1) having a plurality of emitters (12), wherein the optical arrangement (20) comprises an optical distribution means (2) arranged to distribute light emitted by at least one of the emitters (12) to overlap, on a target plane (4), with light from at least one of the other emitters (12) and wherein the optical distribution means (2) comprises at least one diffractive optical element (22).

2. Optical arrangement (20) according to claim 1, wherein the light emitted by at least one of the emitters (12) overlaps with light from at least two or half or essentially all of the other emitters (12).

3. Optical arrangement (20) according to claims 1 or 2, wherein a beam of light in the target plane (4) has a linear extension, in a direction parallel to a main extension of the optical distribution means (2) that is substantially larger or substantially smaller than the extension of the optical distribution means (2) in said direction.

4. Optical arrangement (20) according to claim 1 or 2, comprising optical redirection means (3) that redirect light distributed by the optical distribution means (2) into a given direction.

5. Optical arrangement (20) according to claim 4, wherein a beam of light leaving the optical redirection means (3) has a linear extension, in a direction parallel to a main extension of the optical distribution means (2) and of the optical redirection means (3) that is substantially larger or substantially smaller than the extension of the optical distribution means (2) in said direction.

6. Optical arrangement (20) according to claims 1 through 5, wherein the optical distribution means (2) comprises a single diffractive optical element (22).

7. Optical arrangement (20) according to claim 6, wherein the optical distribution means (2) is a deterministic diffuser.

8. Optical arrangement (20) according to claim 6 dependent on claim 4 or 5, wherein the optical redirection means (3) is implemented in combination with the optical distribution means (2) as a single optical element.

9. Optical arrangement (20) according to claims 1 through 5, wherein the optical distribution means (2) comprises a plurality of distribution elements (22).

10. Linear laser emitting device (10) comprising a linear laser emitting means (1) with a plurality of emitters (12), **characterised in**
**that** the linear laser emitting device (10) comprises an optical distribution means (2) according to one of the claims 1 to 9.

11. Linear laser emitting device (10) according to claim 10 dependent on claim 9, wherein the number of distribution elements (22) is equal to the number of emitters (12).
